# EUROPÄISCHE PATENTSCHRIFT

(11) **EP 0 772 700 B1**
(45) Veröffentlichungstag und Bekanntmachung des Hinweises auf die Patenterteilung: **16.06.1999**
(21) Anmeldenummer: 95915761.1
(22) Anmeldetag: 07.04.1995
(51) Int. Cl.: C25D 5/54

(54) **VERWENDUNG EINER PALLADIUMKOLLOID-LÖSUNG**
USE OF A PALLADIUM COLLOID SOLUTION
UTILISATION D'UNE SOLUTION COLLOIDALE DE PALLADIUM

(30) Priorität: 08.04.1994 DE 4412463
(43) Veröffentlichungstag der Anmeldung: 14.05.1997
(73) Patentinhaber: ATOTECH Deutschland GmbH, 10553 Berlin (DE)
(72) Erfinder: MEYER, Heinrich, D-14109 Berlin (DE); STAMP, Lutz, D-13509 Berlin (DE)
(74) Vertreter: Effert, Udo, Dipl.-Ing.
(86) Internationale Anmeldenummer: DE9500484
(87) Internationale Veröffentlichungsnummer: WO9527813

(56) Entgegenhaltungen:
- WO-A-93/17153

## Beschreibung

Die Erfindung betrifft eine Palladiumkolloid-Lösung, eine Verwendung der Lösung zur Beschichtung elektrisch nichtleitender Substratoberflächen mit metallischen Überzügen sowie eine unter Verwendung der Lösung hergestellte Leiterplatte.

Die Metallisierung elektrisch nichtleitender Substratoberflächen ist an sich bekannt. Sowohl für die Metallisierung von Leiterplatten, Kunststoffteilen für dekorative Anwendungen als auch für funktionelle Zwecke werden galvanotechnische Verfahren eingesetzt. Hierzu werden die Substratoberflächen nach einer geeigneten Vorbehandlung mit einer meist Edelmetall enthaltenden Lösung aktiviert und anschließend stromlos metallisiert. Auf diese erste Metallschicht können gegebenenfalls weitere Metallschichten mit einem elektrolytischen Beschichtungsverfahren aufgebracht werden.

Das stromlose Metallisierungsverfahren weist jedoch erhebliche Nachteile auf (schwierige Prozeßkontrolle der stromlosen Metallisierungsbäder, Verwendung von Formaldehyd als Reduktionsmittel, das in dem Verdacht steht, krebserregend zu sein, Verwendung von abwassertechnisch schwierig handhabbarer Komplexbildner). Daher wurden in der Vergangenheit Anstrengungen unternommen, bessere Verfahren zu entwickeln. Mit einigen Verfahren ist der Prozeßschritt der stromlosen Metallisierung, der zur Erzeugung der elektrischen Oberflächenleitfähigkeit benötigt wurde, nicht mehr erforderlich.

Die für die elektrolytische Metallisierung erforderliche elektrische Oberflächenleitfähigkeit wird bei diesen Verfahren beispielsweise mittels intrinsisch leitfähiger organischer Polymerer erzeugt, indem diese als dünne Schicht auf die Oberflächen aufgebracht werden. In DE 38 06 884 C1, DE 39 28 832 A1, DE 39 31 003 A1, EP 0 206 133 A1 und EP 0 413 109 A2 werden Verfahren unter Verwendung derartiger Polymerschichten und anschließender Metallisierung beschrieben. Bei diesen Verfahren wird die leitfähige Form des Polymers durch eine saure bzw. oxidierende Nachbehandlung des auf der Substratoberfläche adsorbierten Monomeren, bei der das Monomere polymerisiert, erzeugt. Nachteilig ist jedoch, daß die leitfähige Polymerschicht nicht nur auf die nichtleitenden Substratoberflächen aufgebracht wird, sondern sich auch auf metallische Flächen abscheidet, wie beispielsweise die Kupferflächen auf Leiterplatten, so daß nachfolgend abgeschiedene Metallschichten auf diesen Metallflächen nicht ausreichend fest haften können.

In einer anderen Verfahrensvariante werden die Oberflächen mit der leitfähigen organischen Polymerschicht nach der Behandlung mit einem Edelmetall enthaltenden Aktivator beschichtet (DE 42 11 152 C1).

In einer weiteren Verfahrensalternative, die in den Druckschriften DE 39 39 676 C1, DE 41 12 462 A1, DE 42 27 836 A1 sowie GB 22 43 838 A offenbart ist, wird die leitfähige Polymerschicht lediglich auf den nichtleitenden Oberflächen gebildet, indem das nicht leitfähige Monomere in einer sauren Lösung direkt mit auf den nichtleitenden Substratoberflächen adsorbiertem Oxidationsmittel reagiert. Jedoch sind die eingesetzten Monomeren-Verbindungen, aus denen der leitfähige Polymerfilm erzeugt wird, ebenso wie in den vorstehenden Verfahrensvarianten relativ leicht flüchtig, so daß besondere Vorsichtsmaßnahmen für den Arbeitsschutz ergriffen werden müssen.

Weiterhin können, wie in US-PS 46 31 117, US-PS 48 74 477, DE 41 41 416 A1 und WO 92/19092 offenbart, zur Erzeugung der Oberflächen-Leitfähigkeit dünne Kohlenstoffschichten auf die Substratoberflächen aufgebracht werden. Auch in diesem Fall bilden sich die leitfähigen Schichten nicht nur auf den nichtleitenden Substratoberflächen-Bereichen, sondern auch auf metallischen Oberflächen-Bereichen. Daher müssen die Kohlenstoffschichten vor der Metallisierung von diesen Bereichen wieder entfernt werden. Dies erfordert einen zusätzlichen Verfahrensschritt.

In einer weiteren Verfahrensalternative wird die für die elektrolytische Metallisierung benötigte erste Leitschicht durch Behandlung in Edelmetall enthaltenden Lösungen erzeugt. Hierzu wurden verschiedene Verfahrensalternativen beschrieben.

Gemäß US-PS 30 99 608 werden die Substratoberflächen zunächst mit einer Palladium/Zinnoxid-Kolloidlösung und anschließend mit einer Lösung, mit der die adsorbierten Zinnverbindungen von den Oberflächen wieder entfernt werden, behandelt. Die Oberflächen können anschließend mit einer Pyrophosphat enthaltenden Kupferlösung metallisiert werden.

Gemäß DE 33 04 004 A1 werden die Oberflächen ebenfalls mit einer Palladium/Zinnoxid-Kolloidlösung und anschließend mit einer Lösung zur Entfernung der Zinnverbindungen behandelt. Danach kann elektrolytisch metallisiert werden.

Gemäß DE 33 23 476 C2 werden die Oberflächen auch mit einer Palladium/Zinnoxid-Kolloidlösung und anschließend mit einer Lösung, mit der adsorbierte Zinnverbindungen von den Oberflächen entfernt werden, behandelt. Die Oberflächen werden mit Kupferbädern mit speziellen organischen Verbindungen, die die bevorzugte Abscheidung auf den mit Palladiumkolloid beschichteten Oberflächenbereichen ermöglichen, metallisiert.

Gemäß DE 37 41 459 C1 werden die Substratoberflächen nach einer katalytischen Aktivierung, beispielsweise mit einer Palladium/Zinnoxid-Kolloidlösung, mit einer stickstoffhaltige Verbindungen, beispielsweise Polyvinylpyrrolidon, enthaltenden Lösung behandelt und danach elektrolytisch metallisiert.

Gemäß US-PS 47 90 912 und US-PS 48 91 069 werden die Oberflächen mit einer Palladium/Zinnoxid-Kolloidlösung, die zusätzlich einen Stabilisator und einen Promotor enthält, behandelt, wobei der bei der elektrolytischen Abscheidung entstehende Wasserstoff vom adsorbierten Palladium-Kolloid aufgenommen wird und die elektrolytische Metallisierung unterstützt. Als Stabilisator werden Salze von Aluminium, Titan, Zirkonium und Hafnium und als Promotor Stoffe wie organische Hydroxy-, Thioharnstoffverbindungen, oberflächenaktive Verbindungen, Aminosäuren, Polycarbonsäuren und wasserlösliche Polymere eingesetzt. Anschließend kann elektrolytisch metallisiert werden.

Gemäß US-PS 50 71 517 werden die Oberflächen mit einer Palladium/Zinnoxid-Kolloidlösung und anschließend mit einer schwach alkalischen Lösung zur Entfernung der Zinnverbindungen behandelt. Danach kann elektrolytisch metallisiert werden.

Gemäß EP 0 398 019 A1 werden die Substratoberflächen vor der Behandlung mit einer Metall enthaltenden Lösung, wie beispielsweise einer Palladium/Zinnoxid-Kolloidlösung, mit einer Lösung, die eine oberflächenaktive Verbindung enthält und die die Adsorption des Metalls fördert, behandelt.

Die vorgenannten Verfahren haben den Nachteil, daß nur in einem engen Bereich der Verfahrensparameter, der beim technischen Einsatz der Verfahren jedoch kaum eingehalten werden kann, eine ausreichend dichte und porenfreie Metallschicht abgeschieden und eine ausreichend hohe Haftfestigkeit des abgeschiedenen Metallfilmes auch auf den metallischen Bereichen, beispielsweise auf den Kupferflächen einer Leiterplatte, erzielt werden kann.

Gemäß US-PS 39 84 290 wird in einer weiteren Verfahrensalternative auf die gesamte Oberfläche des Substrats ein elektropositiveres (edleres) Metall als das auf dem Substrat in bestimmten Bereichen vorliegende Metall abgeschieden. Bei der Metallisierung von Leiterplatten wird beispielsweise Palladium oder Silber auf die Kupferflächen und die nichtleitenden Bereiche aufgebracht. Anschließend wird die gebildete Metallschicht mit einer Ätzlösung, die lediglich die ursprünglichen Metallflächen (Kupfer) angreift, behandelt, so daß der gebildete edlere Metallfilm von den ursprünglichen Metallflächen wieder entfernt wird. Danach kann elektrolytisch metallisiert werden. Gemäß einer Verfahrensvariante werden die Substratoberflächen im Anschluß an die Beschichtung mit dem edleren Metall mit einer Chalcogen-Verbindungen enthaltenden Lösung behandelt.

In einer weiteren Verfahrensalternative werden die Substratoberflächen zunächst mit einer Edelmetall enthaltenden Kolloidlösung und anschließend mit einer Chalcogenidverbindungen enthaltenden Lösung behandelt. Dabei wird das adsorbierte Edelmetall zu einer gut leitenden und gegen chemische Einflüsse stabilen Edelmetallchalcogenid-Verbindung umgewandelt. Typischerweise wird eine Palladium/Zinnoxid-Kolloidlösung als Aktivator und Natriumsulfid als Chalcogenidverbindung eingesetzt (US-PS 48 95 739, US-PS 49 52 286, US-PS 50 07 990, US-PS 50 17 742).

Gemäß US-PS 48 10 333 werden die Substratoberflächen zunächst mit einer alkalischen Permanganatlösung behandelt. Dabei bildet sich auf den Substratoberflächen eine Braunsteinschicht durch Reaktion des Permanganats mit dem organischen Material des Substrats. Diese Schicht wird nachfolgend mit einer Chalcogenidlösung und anschließend mit einer Edelmetall-Lösung behandelt. Danach wird elektrolytisch metallisiert.

Die Behandlung mit der Chalcogenidlösung führt jedoch auf metallischen Bereichen der Substratoberflächen zu einer Bildung von Metallchalcogeniden, so daß diese Metallchalcogenidschichten vor der nachfolgenden elektrolytischen Metallisierung durch einen Ätzprozeß von den Metallflächen wieder entfernt werden müssen, um eine ausreichende Haftfestigkeit des abgeschiedenen Metalls auf der Metallunterlage zu erreichen. Der Ätzprozeß muß innerhalb enger Parametergrenzen durchgeführt werden, um einerseits nicht die gebildete leitfähige Schicht zu beschädigen und andererseits die gesamte Metallchalcogenidschicht von den Metallflächen zu entfernen.

Gemäß US-PS 49 19 768 werden die zu beschichtenden Oberflächen zunächst mit einer Zinn(II)ionen enthaltenden Lösung, anschließend mit einer Chalcogenidlösung und danach mit einer Lösung eines Edelmetalls, beispielsweise mit Palladiumchlorid, behandelt. Anschließend können die vorbehandelten Substratoberflächen elektrolytisch metallisiert werden. Auch in diesem Fall muß die gebildete Metallchalcogenidschicht von den metallischen Bereichen des Substrats in einem Ätzprozeß wieder entfernt werden. Es entstehen dieselben Probleme wie im vorstehend genannten Fall.

In allen Prozessen, bei denen kolloidale Edelmetall-Lösungen und insbesondere Palladium/Zinnoxid-Kolloidlösungen verwendet werden, besteht das Problem, daß die kolloidalen Lösungen oxidationsempfindlich sind. Dies liegt vor allem an der leichten Oxidierbarkeit der Zinn(ll)-Verbindungen zu Zinn(lV)-Verbindungen. Durch die Oxidation der Zinn-Verbindungen geht der die Kolloidlösung stabilisierende Effekt der Zinn(ll)-lonen verloren, da Zinn(lV)-lonen nicht stabilisierend wirken. Dadurch koaguliert das Kolloid, und Palladium fällt als Niederschlag aus.

Außerdem kann aus Palladium/Zinnoxid-Kolloidlösungen nur eine begrenzte Palladiumkonzentration auf den Substratoberflächen adsorbiert werden. Daher ist die Metallisierbarkeit von Palladiumschichten, die aus diesen Kolloiden adsorbiert werden, geringer als die aus mit organischen Schutzkolloiden stabilisierten Kolloidlösungen.

Eine andere Edelmetallkolloid-Lösung ist in DE 42 03 577 A1 beschrieben. In diesem Fall handelt es sich um Kolloide der Edelmetalloxide, die nach der Adsorption auf den nichtleitenden Substratoberflächen durch einen weiteren Behandlungsschritt zu den entsprechenden Metallen reduziert werden müssen.

Weniger oxidationsempfindlich als die zuvor erwähnten Palladium/Zinnoxid-Kolloidlösungen sind mit organischen Schutzkolloiden stabilisierte Edelmetall-Lösungen. In US-PS 40 04 051, US-PS 46 34 468, US-PS 46 52 311 und US-PS 47 25 314 werden derartige Edelmetall-Lösungen für Verfahren mit stromlosen Metallisierungsbädern, vorzugsweise mit alkalischen Kupferbädern, beschrieben.

In einer weiteren Verfahrensalternative zur direkten elektrolytischen Metallisierung werden die Substratoberflächen gemäß DE 42 06 680 C2 mit mit organischen Schutzkolloiden anstelle von mit Zinn-Verbindungen stabilisierten Edelmetallkolloid-Lösungen behandelt. Außerdem wird zur Entfernung der adsorbierten Schutzkolloid-Verbindungen von den Substratoberflächen eine Lösung verwendet, die Schwefelverbindungen mit Schwefel in der Oxidationsstufe von +1 bis +5 enthält. Dieses Verfahren hat den Vorteil, daß die Beschichtung der nichtleitenden Oberflächenbereiche mit dem Edelmetallkolloid gut gelingt, ohne daß sich eine störende Schicht auf den metallischen Bereichen der zu beschichtenden Oberflächen niederschlägt.

Allerdings sind auch die vorgenannten mit organischen Schutzkolloiden stabilisierten Edelmetallkolloid-Lösungen oxidationsempfindlich, da das kolloidale Edelmetall mit Sauerstoff aus der Luft reagiert, der in die Lösung eingetragen wird. In saurer Lösung wird das kolloidale Palladium durch Oxidation in lösliche Palladiumsalze überführt, so daß das Edelmetallkolloid zerstört wird. Die Kolloidlösungen reagieren insbesondere beim Einsatz in Durchlaufanlagen, die für die Herstellung von Leiterplatten eingesetzt werden und in denen die Behandlungslösungen auf die horizontal geführten Leiterplatten gespritzt oder geschwallt werden, mit Sauerstoff, da die Lösungen in diesem Fall stark bewegt werden und sie daher intensiver mit Luft in Berührung kommen als bei Anwendung eines Tauchverfahrens.

Der vorliegenden Erfindung liegt von daher das Problem zugrunde, die Nachteile des Standes der Technik zu vermeiden und eine Palladiumkolloid-Lösung mit geringer Oxidationsempfindlichkeit sowie ein Verfahren zu finden, um elektrisch nichtleitende Substratoberflächen durch eine direkte elektrolytische Abscheidung von Metall beschichten zu können.

Gelöst wird das Problem durch die Ansprüche 1, 14 und 15. Bevorzugte Ausführungsformen der Erfindung sind in den Unteransprüchen beschrieben.

Die erfindungsgemäße Palladiumkolloid-Lösung ist durch zusätzlich enthaltene Edelmetalle, ausgewählt aus der Gruppe Rhodium, Iridium und Platin oder Verbindungen dieser Metalle oder deren Gemische gekennzeichnet. Durch diese zusätzlich enthaltenen Edelmetalle wird das Problem der Oxidationsempfindlichkeit derartiger Edelmetallkolloid-Lösungen vermieden. Diese Lösungen können ohne weiteres auch über einen längeren Zeitraum intensiv mit Sauerstoff aus der Luft in Kontakt gebracht werden, ohne daß hierbei deren Wirksamkeit beeinträchtigt wird. Beispielsweise in Durchlaufanlagen, die bei der Leiterplattenherstellung eingesetzt werden, kommen diese Lösungen intensiv mit Sauerstoff in Kontakt, da die Lösungen über Sprüh- oder Schwalldüsen an das zu beschichtende Gut herangeführt werden, wobei der Sauerstoff im Sprüh- oder Schwallstrahl von der Lösung aufgenommen wird. In denselben Anlagen werden diese Lösungen außerdem von den Leiterplatten wieder in das meist darunter angeordnete Flüssigkeitsreservoir zurückgeführt, wobei die Flüssigkeit je nach konstruktiver Ausführung der Behandlungsvorrichtung beispielsweise in freiem Fall oder über Leitebenen in das Flüssigkeitsreservoir zurückgelangt. Auch hierbei erfolgt ein inniger Kontakt der Lösung mit dem Sauerstoff aus der Luft.

Da die Lösungen weniger oxidationsempfindlich sind als die bekannten Kolloidlösungen, ist zum Ansatz und zur Ergänzung der zusätzlich Edelmetall enthaltenden Kolloidlösungen ferner weniger Reduktionsmittel erforderlich, ohne daß sich das für die Funktionsfähigkeit der Kolloidlösung erforderliche elektrochemische Reduktions/Oxidationspotential in der Lösung von einem negativen Arbeitswert zu einem positiven Wert verschiebt. Daraus ergibt sich der weitere Vorteil, daß beim Betrieb der Lösungen weniger Chemikalien verbraucht werden.

Darüber hinaus ist der Gehalt an Kupferionen in diesen Lösungen, der durch langsame Auflösung von mit der Lösung in Kontakt stehenden Kupfersubstraten, beispielsweise von Leiterplatten, entsteht, weniger kritisch als bei bekannten Palladiumkolloid-Lösungen. Bei diesen Kolloidlösungen erhöht sich der Verbrauch des Reduktionsmittels in den Lösungen um deren Funktionsfähigkeit zu erhalten, sobald eine kritische Obergrenze der Kupfer-Konzentration überschritten wird. Daher ist der Reduktionsmittel-Verbrauch in älteren Lösungen, in denen bereits eine größere Leiterplattenfläche bearbeitet wurde, erheblich. Sobald die kritische Obergrenze der Kupferkonzentration in diesen Lösungen erreicht ist, kann ein negatives elektrochemisches Reduktions/Oxidationspotential in der Kolloidlösung auch durch weitere Reduktionsmittel-Zugabe nicht mehr aufrechterhalten werden, so daß die Kolloidlösung für die Substratbehandlung unwirksam wird.

Die kritische Obergrenze der Kupferkonzentration liegt für die erfindungsgemäßen Lösungen daher sehr viel höher als für Kolloidlösungen ohne zusätzliche Edelmetalle. Es kann eine größere Leiterplattenfläche in der Kolloidlösung bearbeitet werden, bevor diese Konzentrationsgrenze erreicht wird. Daher sind auch weniger der insbesondere wegen des Edelmetallgehaltes der Kolloidlösung teuren Chemikalien für den Neuansatz derartiger Bäder erforderlich.

In Hypophosphit als Reduktionsmittel enthaltenden Kolloidlösungen wirkt ferner neben Hypophosphit auch Phosphit, das sich in diesen Kolloidlösungen aus Hypophosphit bildet, als Reduktionsmittel, wenn die zusätzlichen Edelmetalle zu der Palladiumkolloid-Lösung zugegeben werden. Dadurch wird der Wirkungsgrad des zugesetzten Hypophosphits als Reduktionsmittel deutlich erhöht.

Die Vorteile, die sich durch die Zugabe der zusätzlichen Edelmetalle zu der Palladiumkolloid-Lösung einstellen, sind außerordentlich überraschend, da es nicht gelingt, elektrisch nichtleitende Substratoberflächen direkt elektrolytisch zu metallisieren, indem für die Vorbehandlung dieser Substratoberflächen allein mit den Edelmetallen Rhodium, Iridium oder Platin hergestellte Kolloidlösungen verwendet werden. Zudem sind Kolloidlösungen der zusätzlichen Edelmetalle ohne Palladium unter den für die Palladiumkolloid-Bildung bevorzugten Bedingungen nicht herstellbar.

Zur Herstellung der neuartigen Kolloidlösung wird zunächst eine Palladiumkolloid-Stammlösung nach bekanntem Verfahren vorgefertigt. Hierzu wird beispielsweise eine Lösung einer Palladiumverbindung zusammen mit einem organischen Schutzkolloid angesetzt und anschließend mit einer Lösung eines Reduktionsmittels gemischt. Das organische Schutzkolloid dient hierbei zur Stabilisierung der Palladiumkolloid-Lösung gegen unerwünschte Palladium-Ausflockung. Es werden vorzugsweise wäßrige Lösungen eingesetzt, die zusätzlich organische Lösemittel enthalten können, beispielsweise um die Löslichkeit bestimmter Verbindungen in der Kolloidlösung oder der zur Herstellung der Kolloidlösung benötigten Ausgangsstoffe in deren Ausgangslösungen erreichen zu können. Derartige Kolloidlösungen werden auch in den Druckschriften US-PS 40 04 051, US-PS 46 34 468, US-PS 46 52 311 und US-PS 47 25 314 beschrieben. Die Verfahrensweise zur Herstellung der Palladiumkolloid-Stammlösung ist daher diesen Druckschriften zu entnehmen.

Als Palladiumverbindungen können alle Stoffe eingesetzt werden, die durch Reduktionsmittel zu metallischem Palladium reduzierbar, einfach handhabbar und in der Ausgangslösung ausreichend gut löslich oder durch Auflösen in der Ausgangslösung in lösliche Verbindungen überführbar sind. Geeignete Stoffe sind anorganische Salze, wie beispielsweise Chloride, Sulfate, Nitrate, Phosphate, Pyrophosphate, Cyanide und Fluoroborate, organische Salze, beispielsweise von Carbonsäuren, wie Ameisen-, Essig-, Bernstein-, Äpfel-, Milch-, Citronen-, Ascorbin-, Oxal-, Benzoe- und Vanillinsäure, sowie Komplexverbindungen, wie beispielsweise Ammin-, Halogenokomplexe und Komplexe mit organischen Komplexbildnern. Besonders gut bewährt haben sich Palladium(11)chlorid und Palladium(II)sulfat in wäßriger salzsaurer Lösung.

Die Palladiumverbindungen können in einer wäßrigen Lösung, gegebenenfalls mit Anteilen organischer Lösemittel, gelöst werden. Wasser als Lösungsmittel in der Kolloidlösung ist aus wirtschaftlichen Gründen zu bevorzugen.

Die Palladium-Konzentration in der Kolloidlösung liegt im Bereich von 50 mg/l bis 1000 mg/l Lösung, vorzugsweise von 100 mg/l bis 500 mg/l Lösung. Es ist vorteilhaft, eine möglichst geringe Palladiumkonzentration, etwa von 250 mg/l Lösung, einzustellen, um den Verlust an teurem Palladium durch Verschleppen der Lösung beim Eintauchen und Wieder-Herausheben der zu beschichtenden Substrate zu minimieren. Andererseits muß die Konzentration so hoch gewählt werden, daß eine ausreichende Adsorption des Palladiums auf den Substratoberflächen erreicht wird, um die Oberflächen nachfolgend problemlos metallisieren zu können.

Zur Stabilisierung der herzustellenden Kolloidlösung werden organische Verbindungen als Schutzkolloide eingesetzt. Hierzu können entweder ionische oder nichtionische, vorzugsweise wasserlösliche Polymere verwendet werden. Zum einen sind natürliche Polymere, wie beispielsweise Proteine, Peptide, Polysaccharide, Gelatine, Agar-Agar, Gummi arabicum, Tannin, zum anderen synthetische Polymere, wie beispielsweise Alkyl- oder Hydroxyalkylcellulose, Polyvinylpyridin, -pyrrolidon, -methylketon, -alkohol, -acetat, Polyimin, Polyacrylsäure, Polyacrylamid, Polyacrylat und deren andere Derivate, Polyethylenglykol, deren Derivate und deren Copolymere, sowie die Mischungen dieser Verbindungen untereinander geeignet. Polyvinylpyrrolidon und insbesondere Poly(4-Vinylpyrrolidon) ist besonders gut geeignet. Das Molekulargewicht dieser Stoffe sollte innerhalb des Bereichs von 1.000 g/Mol bis 10.000.000 g/Mol, vorzugsweise jedoch innerhalb des Bereichs von 2.000 g/Mol bis 2.000.000 g/Mol und besonders bevorzugt innerhalb des Bereichs von 3.000 g/Mol bis 100.000 g/Mol liegen. Das Gewichtsverhältnis dieser Stoffe zu Palladium in der Kolloidlösung ist innerhalb des Bereichs von 1 : 1 bis 100 : 1 und vorzugsweise innerhalb des Bereichs von 3 : 1 bis 10 : 1 einzustellen.

Als Reduktionsmittel werden Verbindungen eingesetzt, die in der Lage sind, die Palladiumverbindungen zu metallischem Palladium zu reduzieren. Die Funktion der Reduktionsmittel besteht jedoch auch darin, das elektrochemische Reduktions/Oxidationspotential in der Kolloidlösung innerhalb eines bestimmten negativen Bereiches aufrechtzuerhalten, indem unerwünschte Nebenreaktionen, beispielsweise die Oxidation des Kolloids, durch die Reduktionsmittel verhindert werden. Die Konzentration des Reduktionsmittels wird daher auch so gewählt, daß ein ausreichend negativer Reduktions/Oxidationspotential-Wert in der Lösung erhalten wird.

Als geeignete Reduktionsmittel sind unter anderem Verbindungen aus den Verbindungsklassen der niederen Alkylaminborane (Mono-, Di-, Trialkylaminborane), wie beispielsweise Dimethylaminboran, Alkalimetall-Borhydride, wie Lithium-, Natrium-, Kaliumborhydrid und insbesondere Natriumborhydrid, Ascorbinsäure, Iso-Ascorbinsäure, Metallhypophosphit, vorzugsweise Alkalimetallhypophosphit, wie beispielsweise Natriumhypophosphit, hypophosphorige Säure, Metallphosphit, vorzugsweise Alkalimetallphosphit, wie beispielsweise Natriumphosphit, phosphorige Säure, Ameisensäure, Formaldehyd, Hydrazin und dessen Derivate, wie beispielsweise Hydrazinhydrat und dessen Salze Hydrazinsulfit, -formiat, -dichlorid, -mononitrat, -monochlorid, -oxalat, -hypophosphit, -phosphit, -orthophosphat und -tartrat sowie dessen Derivate 1,1-Dimethylhydrazin, 1,2-Dimethylhydrazin, Methylhydrazin, Ethylhydrazin, Phenylhydrazin, iso-Propylhydrazin und deren Hydrochloride sowie Hydrazodiessigsäure, weiterhin Hydroxylamin und dessen Derivate, wie beispielsweise α- und β-Hydroxylamine. Zu letzteren gehören die Verbindungen der α- und β-Alkylhydroxylamine mit 1 bis 5 Kohlenstoffatomen in der entweder linearen oder verzweigten Alkylgruppe, wie beispielsweise α- und β-Methylhydroxylamin, α- und β-Ethylhydroxylamin, und ferner α- und β-Arylhydroxylamine, wobei Aryl Phenyl, Benzyl oder Naphthyl ist und mit einer oder mehreren niederen Alkylgruppen substituiert ist, wie beispielsweise α- und β-Phenylhydroxylamin.

Die Kolloidlösung kann weiterhin Halogenidionen, beispielsweise Chloridionen, in einer Konzentration von 0,1 bis 50 g/l Lösung enthalten, wobei deren Gehalt über das stöchiometrische Verhältnis zu Palladium in der Palladiumverbindung hinausgeht. Dadurch wird die Stabilität der Kolloidlösung erhöht und die nach der Behandlung mit der Kolloidlösung durchgeführte elektrolytische Metallabscheidung erleichtert. Es hat sich gezeigt, daß ein erhöhter Gehalt an Halogenidionen in der Kolloidlösung zu einer beschleunigten Metallbeschichtung führt. Falls über das stöchiometrische Verhältnis in der Palladiumverbindung hinausgehend Halogenidionen in der für die Herstellung der Kolloidlösung benötigten Palladiumlösung enthalten sind, stabilisieren diese die Lösung auch gegen eine unerwünschte Ausfällung von Palladiumverbindungen.

Der pH-Wert der Kolloidlösung hat ebenfalls einen Einfluß auf die nachfolgende elektrolytische Metallisierung. Die Lösung ist vorzugsweise im sauren Bereich, vorzugsweise im pH-Bereich von 1 bis 3 und insbesondere im pH-Bereich von 1,2 bis 2,0 einzustellen. Sobald die Kolloidlösung sauer eingestellt ist, wird das Palladiumkolloid wirksamer an den Substratoberflächen adsorbiert. Außerdem erhöht sich die Kolloidstabilität gegen Ausflocken von Palladium.

Zur Herstellung der Palladiumkolloid-Stammlösung wird die Palladium enthaltende Ausgangslösung mit der vorzugsweise wäßrigen Lösung des Reduktionsmittels gemischt. Nach dem Mischen wird die Lösung auf eine erhöhte Temperatur, beispielsweise auf eine Temperatur von 50 bis 70 °C, erhitzt und dabei gegebenenfalls weiteres Reduktionsmittel zugegeben. Während des Mischens wird die vorgelegte Lösung stark bewegt/gerührt, um die Bildung kleinerer Kolloidpartikel zu begünstigen. Es wird vermutet, daß sich Kolloidpartikel in einem Größenbereich von 50 Angstrom bis ungefähr 2000 Angstrom bilden. Die genaue Größe ist nicht bekannt. Vermutlich können Partikel, die eine Größe von etwa 10 µm erreichen, nicht mehr fest auf den Substratoberflächen haften. Daher dürfte ein Kolloid mit Partikelgrößen in dieser Größenordnung nicht mehr wirksam sein. Andererseits sind kleinere Partikel besonders oxidationsempfindlich, da deren spezifische Oberfläche größer ist als die größerer Partikel.

Die Partikelgröße in den Kolloidlösungen hängt von verschiedenen äußeren Einflüssen ab und wird von der Konkurrenz zwischen Keimbildungs- und Keimwachstumsgeschwindigkeit gesteuert. Es ist allgemein bekannt, daß die Partikel umso kleiner sind je schneller die Lösungen gemischt werden, je höher die Temperatur beim Mischen der Lösungen ist und je höher konzentriert Reduktionsmittel und Palladium in den Lösungen sind. Ferner entstehen kleine Kolloidpartikel insbesondere bei Verwendung starker Reduktionsmittel.

Nach dem Mischen der einzelnen Bestandteile der Kolloidlösung wird die erhöhte Temperatur noch während mehrerer Stunden, beispielsweise während weiterer etwa 24 Stunden, aufrechterhalten. Danach werden die zusätzlichen Edelmetalle zugegeben, vorzugsweise nachdem die Lösung auf eine Temperatur von 20 bis 40 °C abgekühlt wurde. Als zusätzliche Edelmetalle werden Rhodium, Iridium und Platin eingesetzt. Bevorzugt sind die dreiwertigen Rhodium-, Iridium- und die zweiwertigen Platinverbindungen, grundsätzlich jedoch auch andere Verbindungen dieser Metalle, einsetzbar. Die Edelmetalle können der Lösung beispielsweise als Salze zugegeben werden. Typischerweise werden hierzu Halogenidsalze, Sulfate, Hydroxide, Cyanide, Phosphate, Pyrophosphate, Phosphite, Hypophosphite, Fluoroborate, Carbonsäuresalze, wie beispielsweise die Salze der Ameisen-, Essig-, Bernstein-, Äpfel-, Milch-, Citronen-, Ascorbin-, Oxal-, Benzoe- oder Vanillinsäure, sowie Komplexverbindungen, wie beispielsweise Ammin-, Halogenokomplexe und Komplexe mit organischen Komplexbildnern, verwendet.

Die Konzentration der zusätzlichen Edelmetalle in der Kolloidlösung wird je nach Palladiumgehalt eingestellt. Bevorzugte Gewichtsverhältnisse von zusätzlichem Edelmetall zu Palladium sind 0,01 : 10 bis 1,0 : 10.

Für das Erreichen der Resistenz der Kolloidlösung gegen Oxidation sind möglicherweise bestimmte Oberflächenstrukturen des zusätzlichen Edelmetalls auf den Kolloidpartikeln verantwortlich. Um die Wirkung dieser Strukturen zu verstehen, werden die möglichen Reaktionen in einer Hypophosphit als Reduktionsmittel enthaltenden Kolloidlösung dargestellt. Hierzu wird auf das weiter unten angegebene Reaktionsschema verwiesen (Es bedeuten: (ads): adsorbierte Verbindung, (gel): in der Lösung gelöste Verbindung, (gas): Verbindung in der Gasphase):

Durch Reaktion (1) wird die desaktivierende Wirkung des gelösten Sauerstoffs für die Kolloidlösung beschrieben, bei der Palladium zu Palladium(II)ionen oxidiert wird. Hypophosphit wird gemäß Reaktion (5) unter Bildung von Wasserstoff katalytisch zu Phosphit oxidiert. Durch Reaktionen (2) und (3) werden mögliche Verbrauchsreaktionen für gelösten Sauerstoff wiedergegeben. Es ist hierbei zu beachten, daß Wasserstoff gemäß Reaktion (4) wahrscheinlich sehr schnell von der Palladiumkolloid-Partikeloberfläche desorbiert, so daß die oberflächen katalysierte Oxidation des Wasserstoffs mittels Sauerstoff zu Wasser gemäß Reaktion (3) nur in untergeordnetem Maße möglich ist. Phosphit wird dagegen gemäß Reaktion (2) nur sehr langsam zu Orthophosphat oxidiert. Daher stellt sich im stationären Zustand ein hoher Gehalt an gelöstem Sauerstoff ein. Dadurch wird Reaktion (1) begünstigt.

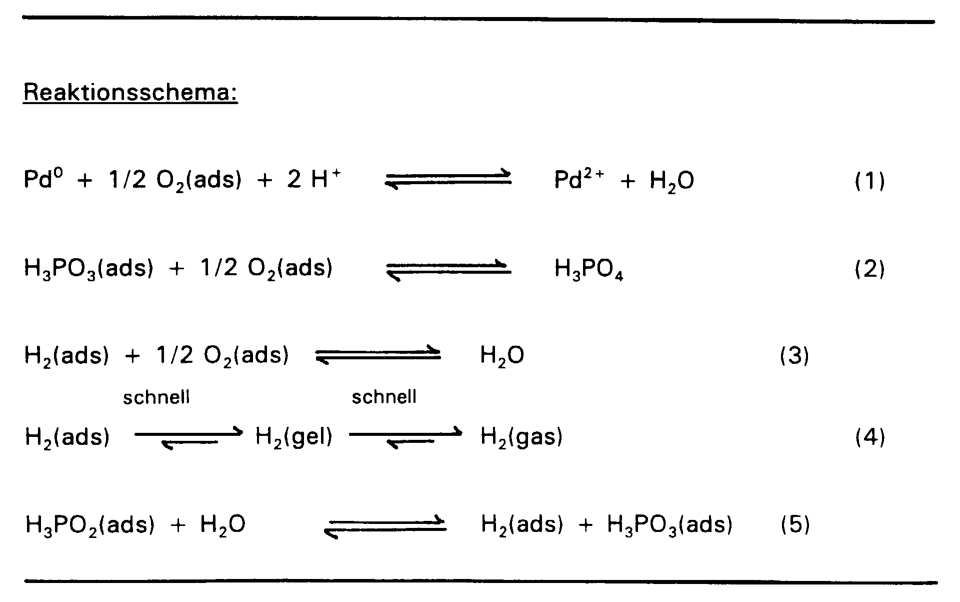

Kupferionen in der Kolloidlösung, die sich beispielsweise in Gegenwart von Sauerstoff durch Auflösen vom Kupfer der Leiterplattenoberflächen in der Lösung anreichern können, fördern offenbar die Reaktion (1) und inhibieren die Reaktionen (2) und (3).

Eine Wirkung der Oberflächenstrukturen des zusätzlichen Metalls auf den Kolloidpartikeln könnte beispielsweise darin bestehen, die Oxidation des Phosphits zu Orthophosphat mit Sauerstoff gemäß Reaktion (2) zu katalysieren, um den Verbrauch gelösten Sauerstoffs zu beschleunigen. Dadurch würde die stationäre Konzentration des gelösten Sauerstoffs deutlich abgesenkt. In der Tat kann ein negatives elektrochemisches Reduktions/Oxidationspotential durch Zugabe von Phosphit zu der Kolloidlösung auch bei der Einwirkung von Sauerstoff aus der Luft aufrechterhalten werden. Diese Wirkung ist dagegen ohne zusätzliche Edelmetalle in der Kolloidlösung nicht beobachtbar.

Nach der Zugabe der zusätzlichen Edelmetalle ist die Kolloidlösung in einem Metallisierungsverfahren einsetzbar.

Eine Überwachung der Kolloidlösung durch Messung des elektrochemischen Reduktions/Oxidationspotentials hat sich als vorteilhaft herausgestellt. Dies ist insbesondere bei Verwendung sich in der Kolloidlösung katalytisch zersetzender Reduktionsmittel, wie beispielsweise bei Borhydrid- und Hypophosphit-Verbindungen, erforderlich, um die nötige Verfahrenssicherheit zu erreichen. Zur Messung des elektrochemischen Reduktions/Oxidationspotentials wird die Spannung zwischen einer in die Kolloidlösung eintauchenden Metallelektrode, beispielsweise einer Gold- oder Platinelektrode, und einer zweiten Elektrode, die in der Lösung ein vorgegebenes Potential einnimmt, gemessen. Als zweite Elektrode kann eine beliebige elektrochemische Standardelektrode, wie beispielsweise eine Silber/ Silberchlorid- oder Kalomelelektrode verwendet werden. Das Potential, das sich nach der Herstellung der Kolloidlösung an der Meßelektrode, gemessen gegen eine Silber/Silberchlorid-Standardelektrode, einstellt, sollte im Bereich zwischen etwa -170 mV bis etwa -300 mV liegen. Durch diese Messung kann die Kolloidlösung überwacht werden. Gegebenenfalls kann das Reduktionsmittel automatisch ergänzt werden, sobald das Potential positiver als beispielsweise -170 mV wird.

Zur Metallbeschichtung von Substratoberflächen werden diese nach bekannten Methoden vorbehandelt. Beispielsweise werden Harzverunreinigungen von Kupferflächen an Leiterplatten durch Harz-Ätzverfahren (beispielsweise mit einem Permanganat-Prozess mit den Verfahrensschritten Vorquellen/Ätzen in alkalischer Permanganatlösung/Reduzieren des gebildeten Braunsteins) und Oxidschichten von den Kupferflächen durch Kupfer-Ätzverfahren (beispielsweise mit Wasserstoffperoxid/Schwefelsäure-Lösungen) entfernt. Ferner kann für eine Benetzung der Harzoberflächen auch eine Netzmittel enthaltende Lösung eingesetzt werden. Hierfür geeignet sind unter anderen nichtionische Netzmittel wie beispielsweise ethoxylierte Alkylphenolether und Polyethylenglykol (Handbuch der Leiterplattentechnik, 1993, Band 3, Seiten 61 bis 69).

Nach dieser Vorbehandlung, bei der die Oberflächen hydrophile Eigenschaften erhalten, werden diese konditioniert, um die nachfolgende Adsorption des Palladiumkolloids zu begünstigen. Als Konditionierungsmittel werden komplexbildende und/oder kationische oberflächenaktive Verbindungen eingesetzt. Typische kationische oberflächenaktive Verbindungen sind in US-PS 43 59 537 aufgeführt. Es handelt sich hierbei um Emulsionscopolymere, die durch allgemein bekannte Verfahren in positiv geladene lonenaustauscherharze durch chemische Reaktion umgewandelt werden.

Als komplexbildende Verbindungen, die konditionierend wirken, können diejenigen Verbindungen verwendet werden, die beispielsweise in Kirk-Othmer, Encyclopedia of Chemical Technology, Third Edition, Volume 5, Seiten 339 - 368 aufgeführt sind.

Als konditionierende Verbindungen werden bevorzugt Stickstoff enthaltende Verbindungen mit einer chemischen Affinität zum Edelmetall eingesetzt. Es handelt sich hierbei insbesondere um kationische Netzmittel, wie beispielsweise Trimethyl-alkyl-ammoniumhalogenide mit geringer Kettenlänge des Alkylrestes, Polyelektrolyte, beispielsweise quaternäre Verbindungen (beispielsweise die in DE 37 43 740 A1, DE 37 43 741 A1, DE 37 43 742 A1, DE 37 43 743 A1, DE 37 43 744 A1 und DE 35 30 617 A1 genannten polyquaternären Verbindungen) und insbesondere die polyquaternären Polyvinylimidazole, sowie Stickstoff enthaltende Komplexbildner, wie beispielsweise die niederen Alkanolamine, wobei die Alkylgruppe 1 bis 5 Kohlenstoffatome enthält und linear oder verzweigt ist. Weitere niedere Alkanolamine, die als Konditionierungsmittel eingesetzt werden können, umfassen Diethanolamin, Triethanolamin, Monoisopropanolamin, Diisopropanolamin, Triisopropanolamin, Mono-sec-butanolamin, Di-sec-butanolamin, 2-Amino-2-methyl-1-propandiol, 2-Amino-2-ethyl-1,3-propandiol, 2-Dimethylamino-2-methyl-1-propanol, Tris(Hydroxymethyl)-aminomethan sowie verschiedene Mischungen der Alkanolamine.

Während der Substratbehandlung wird in der Konditionierungslösung vorzugsweise eine Temperatur von 35 °C bis 60 °C eingestellt. Jedoch kann auch eine höhere Temperatur bis zum Siedepunkt der Lösung oder eine niedrigere Temperatur gewählt werden. Die Behandlungszeit kann außerordentlich kurz sein; grundsätzlich sind bereits einige Sekunden für die Konditionierung der Substratoberflächen ausreichend. Eine obere Grenze ergibt sich lediglich aus wirtschaftlichen Erwägungen. Vorteilhaft sind Behandlungszeiten um 5 Minuten.

Nach der Konditionierung und dem sich anschließenden Spülen der Substratoberflächen werden diese bevorzugt in einer Lösung, die im wesentlichen Reduktionsmittel enthält, behandelt. Dadurch wird der Verlust von Reduktionsmittel in der Kolloidlösung durch Verschleppung beim Eintauchen und Herausheben der Substrate minimiert. Die Temperatur dieser Lösung kann ebenfalls bei Raumtemperatur liegen. Jedoch kann auch eine höhere Temperatur bis zum Siedepunkt der Lösung eingestellt werden.

Danach wird das Substrat ohne weitere Spülprozesse unmittelbar mit der Kolloidlösung in Kontakt gebracht. Hierbei adsorbieren die Palladium-Kolloid - partikel auf den konditionierten elektrisch nichtleitenden Substratoberflächen und bereiten diese für die Metallisierung vor. Die Kolloidlösung wird auf eine gegenüber Raumtemperatur erhöhte Temperatur, beispielsweise 40 °C erwärmt, die Behandlungszeit sollte nicht deutlich unterhalb von 20 Sekunden liegen. Eine vorteilhafte Behandlungszeit liegt zwischen 2 und 7 Minuten.

Gegebenenfalls werden die Substratoberflächen anschließend wieder gespült und danach mit einer Behandlungslösung in Kontakt gebracht, in der eine Chalcogenverbindung mit Chalcogen in den Oxidationsstufen +1 bis +5 enthalten ist. Geeignet sind vorzugsweise Schwefelverbindungen und insbesondere die Verbindungen aus den Substanzklassen der Sulfinsäuren, insbesondere mit 1 bis 5 Kohlenstoffatomen mit linearer oder verzweigter Alkylkette, Sulfite, Thiosulfate, Sulfoxide, Sulfone, Dithionite, Dithionate und andere Verbindungen. Als besonders geeignete Stoffe haben sich hierbei die Verbindungen Hydroxymethansulfinsäure, Alkalisulfit und Alkalithiosulfat herausgestellt. Auch Gemische dieser Verbindungen können vorteilhaft eingesetzt werden. Grundsätzlich sind auch die entsprechenden Selen- und Tellurverbindungen geeignet. Eine besonders gut geeignete Lösung zur Nachbehandlung von Substratoberflächen enthält grundsätzlich zu Natriumthiosulfat auch Natriumcitrat.

Eine über Raumtemperatur (25 °C) erhöhte Temperatur dieser Lösung ist nicht erforderlich. Die Behandlungszeit kann in weiten Bereichen gewählt werden, ohne daß das Behandlungsergebnis beeinflußt wird. Daher sind Zeiten von mindestens einigen Sekunden ausreichend. Eine günstige Behandlungszeit liegt zwischen 1 und 2 Minuten.

Wahrscheinlich wird die organische Schutzkolloidschicht, die durch die Behandlung mit der Kolloidlösung an den Substratoberflächen adsorbiert worden ist, durch die Behandlung mit dieser Lösung von diesen wieder entfernt, so daß die Palladiumkolloid-Partikel freigelegt werden und dadurch ihre Wirkung für die nachfolgende Metallisierung entfalten können.

Nach dieser Behandlung und dem anschließenden Spülen der Substratoberflächen können diese metallisiert werden. Die Metallschicht kann elektrolytisch abgeschieden werden, ohne daß zuvor eine stromlose Metallschicht aufgebracht werden muß. Als Metalle kommen grundsätzlich alle elektrolytisch abscheidbaren Metalle, wie beispielsweise die Metalle Kupfer, Nikkel, Silber, Gold, Palladium, Kobalt, Zinn, Blei, Zink, Chrom, Cadmium, Eisen sowie deren Legierungen und Mischungen untereinander und mit anderen Elementen, beispielsweise mit Phosphor und Bor, in Betracht. Zur Abscheidung von Kupfer wird beispielsweise eine schwefelsaure Kupfersulfat-Lösung (beispielsweise elektrolytisches Kupferbad CUPRACID ® der Firma Atotech Deutschland GmbH, Berlin, Deutschland) verwendet. Selbstverständlich können auf die erste Metallschicht auch weitere Metalle abgeschieden werden.

Weiterhin kann die die zusätzlichen Edelmetalle enthaltende Kolloidlösung auch als Aktivator für die herkömmliche stromlose Metallisierung eingesetzt werden. Derartige Verfahren sind beispielsweise in der US-Patentschrift 46 34 468 beschrieben. Eine zusätzliche Verfahrensvariante, die in der vorstehenden Druckschrift nicht offenbart ist, besteht darin, das Substrat gemäß den vorstehenden Ausführungen nach der Behandlung mit der Kolloidlösung mit der vorstehend beschriebenen Chalcogenlösung zu behandeln.

Für die Metallisierung können die Substratoberflächen in einem Tauchprozeß behandelt werden. Die Vorteile der die zusätzlichen Edelmetalle enthaltenden Kolloidlösung zeigen sich jedoch insbesondere bei der Anwendung von Sprüh- und Schwallstrahlen, da sich die Oxidationsempfindlichkeit der bekannten Palladiumkolloid-Lösungen vor allem bei diesen Behandlungsmethoden nachteilig auswirkt. Durch die vorteilhafte Wirkung der zusätzlichen Edelmetalle in der Kolloidlösung sind die neuen Palladiumkolloid-Lösungen deutlich stabiler gegen Oxidation als die bekannten Kolloidlösungen.

Zur Metallisierung von gebohrten, gestanzten oder auf sonstige Weise erzeugten Löchern in Leiterplatten werden diese sowohl im üblichen Tauchverfahren als auch in Durchlaufanlagen mit den erfindungsgemäßen Kolloidlösungen behandelt. In Durchlaufanlagen werden die Leiterplatten in der Behandlungsanlage in horizontaler Richtung bewegt und mittels Schwall- oder Sprühdüsen mit den Behandlungslösungen in Kontakt gebracht. Daher ist die neuartige Kolloidlösung besonders für diese Anwendung geeignet. Ohne Zugabe der zusätzlichen Edelmetalle zur Palladiumkolloid-Lösung ist eine Behandlung der Leiterplatten in Durchlaufanlagen technisch und wirtschaftlich nicht möglich.

Die die zusätzlichen Edelmetalle enthaltende Palladiumkolloid-Lösung kann für die Metallisierung unterschiedlicher Substrate eingesetzt werden. Neben der Metallisierung von Bohrungen in Leiterplatten können auch andere Substrate für die Elektronik, wie beispielsweise Hybridträger für integrierte Schaltungen sowie Multichipmodule, ferner Kunststoffe für den dekorativen Anwendungsbereich, wie beispielsweise im Automobilbau, in der Sanitärtechnik, für Möbelbeschläge, Modeschmuck, sowie den funktionellen Bereich, wie beispielsweise für gegen elektromagnetische Strahlung abgeschirmte Gehäuse und Reflektoren, mit dieser Lösung für die nachfolgende Metallisierung beschichtet werden.

Die folgenden Beispiele sollen die Erfindung näher erläutern:

### Beispiel 1:

Eine Palladiumkolloid-Lösung wurde durch Mischen zweier Lösungen hergestellt:
- Lösung 1:: Auflösen von 4 g Palladium(II)chlorid in 27 ml wäßriger konzentrierter Salzsäure (37 Gew.%),
Ergänzen der Lösung mit deionisiertem Wasser zu 1 l Lösung, Auflösen von 20 g Poly(4-Vinylpyrrolidon) in der Lösung.
- Lösung 2:: Vorlegen von 1 l deionisiertem Wasser,
Auflösen von 50 g Natriumhypophosphit, NaH₂PO₂·H₂O.
In einem Behälter wurden zunächst 800 ml deionisiertes Wasser vorgelegt, anschließend 100 ml der Lösung 1 zu dem Wasser zugegeben und danach 30 ml der Lösung 2 hinzugefügt. Anschließend wurde die Lösung auf 70 °C erhitzt. Während des Erhitzens wurden weiterhin 70 ml der Lösung 2 langsam und unter ständigem Rühren zugegeben. Die Lösung färbte sich hierbei langsam dunkel.
- Lösung 3:: Auflösen von 1,5 g Rhodium(III)chlorid oder 1,0 g Rhodium(III)oxidhydrat in 25 ml wäßriger konzentrierter Salzsäure (37 Gew.%),
Auffüllen der Lösung mit deionisiertem Wasser auf 1 l Endvolumen.
Danach wurde die Lösung weitere 24 Stunden bei der Temperatur von 70 °C belassen. Nach dem Abkühlen der Lösung auf etwa 40 °C wurden 10 ml der Lösung 3 und anschließend weitere 2 ml der Lösung 2 zugegeben. Danach war die Lösung betriebsbereit.

### Beispiel 2:

- Lösung 4:: Vorlegen von 1 l deionisiertem Wasser,
Zugeben von 50 ml hypophosphoriger Säure (50 Gew.%).
- Lösung 5:: Auflösen von 1,5 g Platin(II)chlorid in 25 ml wäßriger konzentrierter Salzsäure (37 Gew.%),
Auffüllen der Lösung mit deionisiertem Wasser auf 1 l Endvolumen.

Es wurde eine kolloidale Lösung wie in Beispiel 1 hergestellt, jedoch wurde anstelle der Lösung 2 die Lösung 4 und anstelle der Lösung 3 die Lösung 5 verwendet.

### Beispiel 3:

- Lösung 6:: Auflösen von 2,5 g Iridium(III)chlorid in 25 ml wäßriger konzentrierter Salzsäure (37 Gew.%),
Auffüllen der Lösung mit deionisiertem Wasser auf 1 l Endvolumen.
Es wurde eine kolloidale Lösung wie in Beispiel 1 hergestellt, jedoch wurde anstelle der Lösung 3 die Lösung 6 verwendet.

### Beispiel 4:

- Lösung 7:: Auflösen von 0,05 g Rhodium(III)oxidhydrat und 0,08 g Platin(II)chlorid in 25 ml wäßriger konzentrierter Salzsäure (37 Gew.%),
Auffüllen der Lösung mit deionisiertem Wasser auf 1 l Endvolumen.

Es wurde eine kolloidale Lösung wie in Beispiel 1 hergestellt, jedoch wurde anstelle der Lösung 3 die Lösung 7 verwendet.

Die erhaltene Kolloidlösung weist eine etwas höhere Oxidationsempfindlichkeit auf als die in den Beispielen 1 bis 3 erhaltenen Lösungen.

### Beispiel 5:

- Lösung 8:: Auflösen von 0,08 g Rhodium(III)chlorid und 0,13 g Iridium(lll)chlorid in 25 ml wäßriger konzentrierter Salzsäure (37 Gew.%),
Auffüllen der Lösung mit deionisiertem Wasser auf 1 l Endvolumen.

Es wurde eine kolloidale Lösung wie in Beispiel 1 hergestellt, jedoch wurde anstelle der Lösung 3 die Lösung 8 verwendet.

Die erhaltene Kolloidlösung weist eine etwas höhere Oxidationsempfindlichkeit auf als die in den Beispielen 1 bis 3 erhaltenen Lösungen.

### Beispiel 6:

Eine gebohrte Leiterplatte wurde in einem Tauchverfahren nach folgendem Verfahrensablauf metallisiert:

| | Behandl.zeit | Temperatur |
|---|---|---|
| 1. Vorbehandeln mit einer Netzmittel enthaltenden Lösung Spülen | 2 - 5 min 1 - 2 min | 50 °C |
| 2. Anätzen der Kupferflächen in einer Wasserstoffperoxid/Schwefelsäure-Lösung Spülen | 2 min 2 min | 25 °C |
| 3. Konditionieren mit quaternärem Polyelektrolyt (bspw. quaternisiertes Polyvinylimidazol) in wäßriger Lösung (pH-Wert: 8 - 9) Spülen | 5 min | 35 - 60 °C |
| 4. Behandeln mit einer salzsauren Natriumhypophosphit-Lösung | 1 min | 25 °C |
| 5. Behandeln mit der Lösung gemäß Beispiel 1 Spülen | 4 - 7 min | 30 - 50 °C |
| 6. Behandeln in einer wäßrigen Natriumthiosulfat/Natriumcitrat-Lösung Spülen | 1 - 2 min | 25 °C |
| 7. Kupferflächen mit verdünnter Schwefelsäure reinigen Spülen | 1 min | |
| 8. Elektrolytisch Verkupfern (beispielsweise mit schwefelsaurem Kupfersulfat-Elektrolyt) | | |

Es wurde eine dichte und porenfreie Kupferschicht auf den Bohrlochwänden erhalten, die bereits nach wenigen Minuten Elektrolysezeit geschlossen war.

### Beispiele 7 und 8:

Eine gebohrte Leiterplatte wurde in dem Tauchverfahren gemäß Beispiel 6 metallisiert. In Verfahrensschritt 5. wurden anstelle der Palladiumkolloid-Lösung aus Beispiel 1 die Palladiumkolloid-Lösungen aus den Beispielen 2 und 3 verwendet.

Es wurde eine dichte und porenfreie Kupferschicht auf den Bohrlochwänden erhalten, die bereits nach wenigen Minuten Elektrolysezeit geschlossen war.

### Beispiele 9 bis 11:

Jeweils 100 ml der Palladiumkolloid-Lösungen, die gemäß den Beispielen 1 bis 3 hergestellt wurden, wurden in einem Becherglas mit 600 Umdrehungen pro Minute auf einem Magnetrührer gerührt und auf diese Weise einer verstärkten Lufteinwirkung ausgesetzt. Das elektrochemische Reduktions/Oxidationspotential der Lösungen wurde mit einer Platinelektrode, bezogen auf eine Silber/Silberchlorid-Bezugselektrode, gemessen. Das Potential an der Platinelektrode stellte sich nach wenigen Minuten auf Werte zwischen -170 und -250 mV ein und blieb innerhalb dieses Bereiches konstant.

### Beispiel 12

Beispiel 6 wurde in einer Durchlaufanlage wiederholt, in der die Leiterplatte in horizontaler Lage kontinuierlich zwischen Rollen geführt und von einer Behandlungsstation zur nächsten transportiert wird. Die Behandlungslösungen werden durch Düsen an die Leiterplatte und in die Bohrlöcher gespritzt. Die Behandlungszeiten sind kürzer als im Beispiel 6; sie betragen nur etwa 20 % der dort angegebenen Zeiten. Obwohl die Palladiumkolloid-Lösung in der Durchlaufanlage infolge der intensiven Bewegung der Lösung verstärkt mit Luft in Berührung kommt, ist sie auch über längere Zeit stabil. Selbst nach einer kontinuierlichen Durchführung des Verfahrens über einen Zeitraum von mehreren Tagen kann das in der Palladiumkolloid-Lösung gemessene elektrochemische Reduktions / Oxidationspotential bei etwa -250mV, gemessen gegen eine Silber / Silberchlorid-Standardelektrode annähernd konstant gehalten werden. Nach dem Durchlauf aller Stationen wird eine dichte und porenfreie Kupferschicht auf den Bohrlochwänden erhalten, die nach wenigen Minuten Behandlungszeit in der Verkupferungslösung geschlossen war. Dieses Ergebnis konnte auch bei einer Versuchsdurchführung mit einer mehrere Tage lang in Betrieb befindlichen Lösung erreicht werden.

### Beispiel 13 (Vergleichsbeispiel):

Aus 870 ml deionisiertem Wasser, 100 ml der gemäß Beispiel 1 erhaltenen Lösung 1 und 30 ml der gemäß Beispiel 1 erhaltenen Lösung 2 wurde ein herkömmliches, nicht zusätzlich mit Edelmetallen stabilisiertes Palladiumkolloid hergestellt. Dieses Kolloid wurde wie in den Beispielen 9 bis 11 einer verstärkten Lufteinwirkung ausgesetzt und das elektrochemische Reduktions/Oxidationspotential in der Lösung gemessen. Innerhalb weniger Minuten nach Beginn der Lufteinwirkung veränderte sich das Potential von ursprünglich etwa -300 mV zu positiveren Werten hin. Nach kurzer Einwirkzeit wurden Werte von etwa + 400 mV an der Platinelektrode gemessen.

## Patentansprüche

1. Verfahren zur Beschichtung elektrisch nichtleitender Substratoberflächen mit metallischen Überzügen mit den Verfahrensschritten:
a. Behandeln der Substratoberflächen mit einer Palladiumkolloid-Lösung mit geringer Oxidationsempfindlichkeit, enthaltend mindestens ein zinnfreies Reduktionsmittel und mindestens ein organisches Schutzkolloid zur Stabilisierung der Kolloidlösung und zusätzlich mindestens ein Edelmetall, ausgewählt aus der Gruppe, bestehend aus Rhodium, Iridium und Platin, oder mindestens eine Verbindung dieser Edelmetalle, oder ein Gemisch dieser Edelmetalle und dieser Verbindungen,
b. bedarfsweise Abspülen störender Reste der Palladiumkolloid-Lösung von den Substratoberflächen,
c. Metallisieren der Substratoberflächen mit einer Metallisierungslösung.

2. Verfahren nach Anspruch 1, dadurch gekennzeichnet, daß Verbindungen der Edelmetalle, ausgewählt aus der Gruppe, bestehend aus dreiwertigen Rhodium-, Iridium- und zweiwertigen Platinverbindungen, verwendet werden.

3. Verfahren nach einem der vorstehenden Ansprüche, dadurch gekennzeichnet, daß eine Palladium-Konzentration von 50 mg/l bis 1000 mg/l Lösung, insbesondere von 100 mg/l bis 500 mg/l Lösung und bevorzugt etwa 250 mg/l Lösung, eingestellt wird.

4. Verfahren nach einem der vorstehenden Ansprüche, dadurch gekennzeichnet, daß ein Gewichtsverhältnis der zusätzlichen Edelmetalle zu Palladium von 0,01 : 10 bis 1,0 : 10, eingestellt wird.

5. Verfahren nach einem der vorstehenden Ansprüche, dadurch gekennzeichnet, daß Reduktionsmittel, ausgewählt aus der Gruppe, bestehend aus
Metallhypophosphit, Metallphosphit und deren Säuren,
Alkalimetallborhydrid,
Monoalkylaminboran,
Dialkylaminboran,
Trialkylaminboran,
Ascorbinsäure, Iso-Ascorbinsäure,
Hydrazin und dessen Derivaten,
Hydroxylamin und dessen Derivaten,
Formaldehyd
eingesetzt werden.

6. Verfahren nach einem der vorstehenden Ansprüche, dadurch gekennzeichnet, daß die organischen Schutzkolloide im Gewichtsverhältnis des Schutzkolloids zu Palladium von 1 : 1 bis 100 : 1 eingesetzt werden.

7. Verfahren nach einem der vorstehenden Ansprüche, dadurch gekennzeichnet, daß Schutzkolloide, ausgewählt aus der Gruppe, bestehend aus
Polyvinylpyrrolidon,
Polyvinylpyridin,
Polyvinylmethylketon,
Polyvinylalkohol,
Polyvinylacetat,
Polyacrylsäure und deren Derivaten,
Polyethylenglykol,
Polyimin,
Alkyl- und Hydroxyalkylcellulose
und deren Copolymeren,
eingesetzt werden.

8. Verfahren nach einem der vorstehenden Ansprüche, dadurch gekennzeichnet, daß ein pH-Wert von 1 bis 3, vorzugsweise von 1,2 bis 2,0, in der Palladiumkolloid-Lösung eingestellt wird.

9. Verfahren nach einem der vorstehenden Ansprüche, dadurch gekennzeichnet, daß ein negatives elektrochemisches Reduktions/Oxidationspotential in der Palladiumkolloid-Lösung, vorzugsweise im Bereich von -170 mV bis -300 mV, gemessen gegen eine Silber/Silberchlorid-Standardelektrode, eingestellt wird.

10. Verfahren nach einem der vorstehenden Ansprüche, dadurch gekennzeichnet, daß die Substratoberflächen zwischen den Verfahrensschritten b. und c. mit einer Lösung, enthaltend eine Schwefelverbindung mit Schwefel in der Oxidationsstufe von mindestens +1 bis höchstens + 5, vorzugsweise einer wäßrigen Lösung von Natriumthiosulfat und Natriumcitrat, behandelt werden.

11. Verfahren nach einem der vorstehenden Ansprüche, dadurch gekennzeichnet, daß die Substratoberflächen elektrolytisch metallisiert werden.

12. Verfahren nach einem der vorstehenden Ansprüche, dadurch gekennzeichnet, daß die Substratoberflächen vor der Behandlung gemäß Verfahrensschritt a. mit einer Lösung, enthaltend mindestens eine Verbindung, ausgewählt aus der Gruppe, bestehend aus quaternären, vorzugsweise polyquaternären Verbindungen, in Kontakt gebracht und anschließend bedarfsweise gespült werden.

13. Verfahren nach einem der vorstehenden Ansprüche, dadurch gekennzeichnet, daß die Substratoberflächen mit einer Kupferlösung metallisiert werden.

14. Anwendung des Verfahrens nach einem der vorstehenden Ansprüche zur Metallisierung von Löchern in Leiterplatten.

15. Verfahren zur Herstellung einer Palladiumkolloid-Lösung mit geringer Oxidationsempfindlichkeit, enthaltend mindestens ein zinnfreies Reduktionsmittel und mindestens ein organisches Schutzkolloid zur Stabilisierung der Kolloidlösung und zusätzlich mindestens ein Edelmetall, ausgewählt aus der Gruppe, bestehend aus Rhodium, Iridium und Platin, oder mindestens eine Verbindung dieser Edelmetalle, oder ein Gemisch dieser Edelmetalle und dieser Verbindungen, gekennzeichnet durch folgende Verfahrensschritte:
a. Herstellen einer vorgefertigten Stammlösung aus einer Palladiumverbindung, dem mindestens einen organischen Schutzkolloid und dem mindestens einen Reduktionsmittel in verdünnter wäßriger Salzsäure,
b. Erhitzen der Lösung auf 50°C bis 70°C, gegebenenfalls weitere Zugabe von Reduktionsmittel zu der Lösung und Aufrechterhalten der Temperatur der Lösung während etwa 24 Stunden,
c. nach dem Abkühlen der Lösung auf 20°C bis 40°C, Zugeben mindestens einer der zusätzlichen Edelmetallverbindungen.

## Claims

1. Method of coating electrically non-conductive substrate surfaces with metallic coatings, having the following method steps:
a. treating the substrate surfaces with a palladium colloid solution, having a low sensitivity to oxidation and containing at least one tin-free reducing agent and at least one organic protective colloid for stabilising the colloid solution and additionally at least one noble metal, selected from the group including rhodium, iridium and platinum, or at least one compound of these noble metals, or a mixture of these noble metals and these compounds,
b. rinsing, if necesary, undesirable residues of the palladium colloid solution from the substrate surfaces, and
c. metallising the substrate surfaces with a metallising solution.

2. Method according to claim 1, characterised in that compounds of the noble metals are used, selected from the group including trivalent rhodium and iridium and bivalent platinum compounds.

3. Method according to one of the preceding claims, characterised in that a palladium concentration is set between 50 mg/l and 1000 mg/l solution, more especially between 100 mg/l and 500 mg/l solution, and preferably substantially 250 mg/l solution.

4. Method according to one of the preceding claims, characterised in that a weight ratio of the additional noble metals to palladium is set between 0.01:10 and 1.0:10.

5. Method according to one of the preceding claims, characterised in that reducing agents are used, selected from the group including
metal hypophosphite, metal phosphite and their acids,
alkali-metal boron hydride,
monoalkylamine borane,
dialkylamine borane,
trialkylamine borane,
ascorbic acid, iso-ascorbic acid,
hydrazine and its derivatives,
hydroxylamine and its derivatives, and
formaldehyde.

6. Method according to one of the preceding claims, characterised in that the organic protective colloids are used in the weight ratio of the protective colloid to palladium of between 1:1 and 100:1.

7. Method according to one of the preceding claims, characterised in that protective colloids are used, selected from the group including
polyvinylpyrrolidone,
polyvinylpyridine,
polyvinylmethylketone,
polyvinylalcohol,
polyvinylacetate,
polyacrylic acid and its derivatives,
polyethylene glycol,
polyimine, and
alkyl and hydroxyalkyl cellulose
and its copolymers.

8. Method according to one of the preceding claims, characterised in that a pH value of between 1 and 3, preferably between 1.2 and 2.0, is set in the palladium colloid solution.

9. Method according to one of the preceding claims, characterised in that a negative electrochemical reduction/oxidation potential is set in the palladium colloid solution, preferably in the range of between -170 mV and -300 mV, measured relative to a silver/silver chloride standard electrode.

10. Method according to one of the preceding claims, characterised in that, between the method steps b. and c., the substrate surfaces are treated with a solution containing a sulphur compound with sulphur in the oxidation stage of between at least +1 and at most +5, preferably an aqueous solution of sodium thiosulphate and sodium citrate.

11. Method according to one of the preceding claims, characterised in that the substrate surfaces are electrolytically metallised.

12. Method according to one of the preceding claims, characterised in that, prior to the treatment according to method step a., the substrate surfaces are brought into contact with a solution containing at least one compound selected from the group including quaternary, preferably polyquaternary, compounds, and subsequently rinsed if necessary.

13. Method according to one of the preceding claims, characterised in that the substrate surfaces are metallised with a copper solution.

14. Use of the method according to one of the preceding claims for metallising holes in printed circuit boards.

15. Method of producing a palladium colloid solution having a low sensitivity to oxidation and containing at least one tin-free reducing agent and at least one organic protective colloid for stabilising the colloid solution and additionally at least one noble metal, selected from the group including rhodium, iridium and platinum, or at least one compound of these noble metals, or a mixture of these noble metals and these compounds, characterised by the following method steps:
a. producing a prefabricated stock solution from a palladium compound, from at least one organic protective colloid and from at least one reducing agent in dilute aqueous hydrochloric acid,
b. heating the solution to between 50° C and 70° C, possibly additionally adding reducing agent to the solution and maintaining the temperature of the solution for substantially 24 hours, and
c. after cooling the solution to between 20° C and 40° C, adding at least one of the additional noble metal compounds.

## Revendications

1. Procédé de revêtement de surfaces de substrats électriquement non conducteurs avec des couches métalliques, comprenant les étapes consistant à:
a) traiter les surfaces des substrats avec une solution colloïdale de palladium ayant une faible sensibilité à l'oxydation, contenant au moins un agent réducteur sans étain et au moins un colloïde protecteur organique destiné à stabiliser la solution colloïdale et, en plus, au moins un métal précieux choisi dans le groupe comprenant le rhodium, l'iridium et le platine ou bien au moins un composé de ces métaux précieux ou bien un mélange de ces métaux précieux et de ces composés ;
b) éliminer par lavage des surfaces des substrats, si nécessaire, des résidus gênants de solution colloïdale de palladium ;
c) métalliser les surfaces des substrats avec une solution de métallisation.

2. Procédé selon la revendication 1, caractérisé en ce que l'on utilise des composés de métaux précieux choisis dans le groupe comprenant des composés de rhodium et d'iridium trivalents et des composés de platine divalents.

3. Procédé selon l'une quelconque des revendications précédentes, caractérisé en ce que la concentration de palladium est ajustée de 50 mg/l à 1000 mg/l de solution, et notamment de 100 mg/l à 500 mg/l de solution, de préférence à environ 250 mg/l de solution.

4. Procédé selon l'une quelconque des revendications précédentes, caractérisé en ce qu'un rapport en poids des métaux nobles supplémentaires au palladium est ajusté de 0,01/10 à 1,0/10.

5. Procédé selon l'une quelconque des revendications précédentes, caractérisé en ce que l'on utilise des agents réducteurs choisis dans le groupe comprenant les substances suivantes :
hypophosphite métallique, phosphite métallique et leurs acides,
hydruroborate de métal alcalin,
monoalkylaminoborane,
dialkylaminoborane,
trialkylaminoborane,
acide ascorbique, acide iso-ascorbique,
hydrazine et ses dérivés,
hydroxylamine et ses dérivés,
formaldéhyde.

6. Procédé selon l'une quelconque des revendications précédentes, caractérisé en ce que l'on utilise les colloïdes protecteurs organiques dans un rapport en poids du colloïde protecteur au palladium de 1/1 à 100/1.

7. Procédé selon l'une quelconque des revendications précédentes, caractérisé en ce que l'on utilise des colloïdes protecteurs choisis dans le groupe comprenant les substances suivantes :
polyvinylpyrrolidone,
polyvinylpyridine,
polyvinylméthylcétone,
alcool polyvinylique,
polyacétate de vinyle,
acide polyacrylique et ses dérivés,
polyéthylène glycol,
polyimine,
alkyl- et hydroxyalkylcellulose,
ainsi que des copolymères de ces substances.

8. Procédé selon l'une quelconque des revendications précédentes, caractérisé en ce que le pH de la solution colloïdale de palladium est ajusté de 1 à 3, de préférence de 1,2 à 2,0.

9. Procédé selon l'une quelconque des revendications précédentes, caractérisé en ce que l'on ajuste la solution colloïdale de palladium à un potentiel de réduction/oxydation électrochimique négatif, de préférence dans la plage de -170 mV à -300 mV, mesuré par rapport à une électrode argent/chlorure d'argent normalisée.

10. Procédé selon l'une quelconque des revendications précédentes, caractérisé en ce que l'on traite les surfaces des substrats entre les étapes de procédé b) et c) avec une solution contenant un composé de soufre dans lequel le soufre a un degré d'oxydation allant d'au moins +1 à au plus +5, de préférence une solution aqueuse de thiosulfate de sodium et de citrate de sodium.

11. Procédé selon l'une quelconque des revendications précédentes, caractérisé en ce que les surfaces des substrats sont métallisées électrolytiquement.

12. Procédé selon l'une quelconque des revendications précédentes, caractérisé en ce que les surfaces des substrats sont mises en contact avant le traitement suivant l'étape de procédé a) avec une solution contenant au moins un composé choisi dans le groupe comprenant des composés quaternaires, de préférence polyquaternaires, et ensuite rincées si nécessaire.

13. Procédé selon l'une quelconque des revendications précédentes, caractérisé en ce que les surfaces des substrats sont métallisées avec une solution de cuivre.

14. Utilisation du procédé selon l'une quelconque des revendications précédentes pour la métallisation de trous dans des circuits imprimés.

15. Procédé de préparation d'une solution colloïdale de palladium ayant une faible sensibilité à l'oxydation, contenant au moins un agent réducteur sans étain et au moins un colloïde protecteur organique destiné à stabiliser la solution colloïdale et, en plus, au moins un métal précieux choisi dans le groupe comprenant le rhodium, l'iridium et le platine ou au moins un composé de ces métaux précieux ou un mélange de ces métaux précieux et de ces composés, caractérisé en ce qu'il comprend les étapes consistant à:
a) préparer une solution mère réalisée à l'avance à partir d'un composé de palladium auquel on ajoute au moins un colloïde protecteur organique et au moins un agent réducteur dans de l'acide chlorhydrique aqueux dilué ;
b) chauffer la solution entre 50 °C et 70 °C, le cas échéant ajouter de l'agent réducteur supplémentaire à la solution et maintenir la température de la solution pendant environ 24 heures ;
c) après refroidissement de la solution entre 20 °C et 40 °C, ajouter au moins un des composés de métal précieux supplémentaires.
